Europäisches Patentamt

European Patent Office

Office européen des brevets

(19)

(11) Veröffentlichungsnummer: **0 345 473 B1**

(12) # EUROPÄISCHE PATENTSCHRIFT

(45) Veröffentlichungstag der Patentschrift: **07.01.93**

(51) Int. Cl.⁵: **B23K 11/24**, G01R 19/10

(21) Anmeldenummer: **89108285.1**

(22) Anmeldetag: **09.05.89**

(54) **Schaltung zum Messen des Spannungsabfalls zwischen den Schweisselektroden einer Widerstandsschweissmaschine.**

(30) Priorität: **10.06.88 CH 2244/88**

(43) Veröffentlichungstag der Anmeldung:
**13.12.89 Patentblatt 89/50**

(45) Bekanntmachung des Hinweises auf die
Patenterteilung:
**07.01.93 Patentblatt 93/01**

(84) Benannte Vertragsstaaten:
**CH DE ES FR GB IT LI NL SE**

(56) Entgegenhaltungen:
**GB-A- 2 083 235**
**GB-A- 2 127 564**
**US-A- 4 714 816**

(73) Patentinhaber: **ELPATRONIC AG**
**Baarerstrasse 112**
**CH-6300 Zug(CH)**

(72) Erfinder: **Mueller, Willi**
**Bahnhofstrasse 50**
**CH-8965 Berikon(CH)**

EP 0 345 473 B1

## Beschreibung

Die Erfindung betrifft eine Schaltung zum Messen des Spannungsabfalls an der Schweissstelle zwischen den Schweisselektroden einer Widerstandsschweissmaschine, mit einer zur Messung einer ersten Schleifenspannung vorgesehenen ersten Messschleife, die einerseits mit Eingängen einer Auswerteschaltung und anderseits mit zwei ersten Abgreifpunkten an den Schweisselektroden verbunden ist, und mit einer zur Messung einer zweiten Schleifenspannung vorgesehenen zweiten Messschleife, die einerseits an weiteren Eingängen der Auswerteschaltung und anderseits an zwei zweiten Abgreifpunkten angeschlossen ist, wobei die Auswerteschaltung die zweite Schleifenspannung von der ersten subtrahiert, und wobei die erste Messschleife einen effektiven Spannungsabfall plus Einstreuungen misst.

Bei der Herstellung von Dosenrümpfen auf Widerstands-Nahtschweissmaschinen wird die Qualität der Schweissnaht durch eine ganze Reihe von Faktoren beeinflusst. Mit Hilfe von Messschaltungen werden daher einzelne dieser Einflussfaktoren gemessen, und aufgrund des erhaltenen Wertes wird eine Auswurfvorrichtung zum Auswerfen der Dosenrümpfe betätigt, wenn Abweichungen von einem gegebenen Sollwert eines bestimmten Parameters, wie beispielsweise der Temperatur der Schweißnaht, auftreten (CH-PS 653 786).

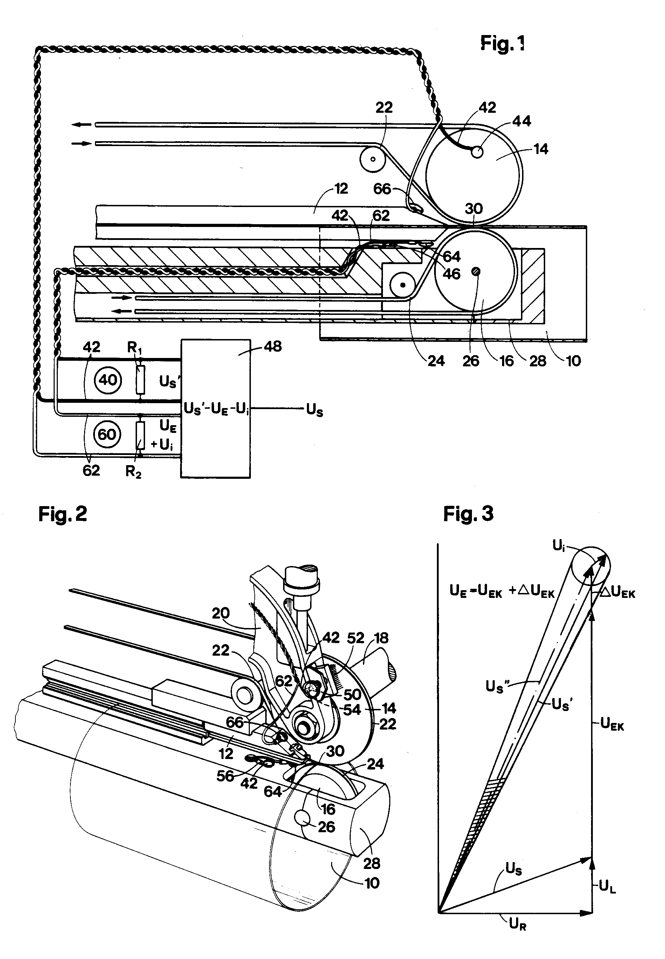

Mit Hilfe einer bekannten Meßschaltung der eingangs genannten Art (US-PS 4 449 028) wird das Zeitintegral der ohmschen Komponente der Schweißspannung über den Halbperioden des Schweißstroms bei einer Wechselstromwiderstandsnahtschweißmaschine bestimmt, welches ein Maß für die beim Schweißen verbrauchte Energie ist und zum Steuern einer Auswurfvorrichtung benutzt wird. Die Spannung, die in der bekannten Meßschaltung als erste Schleifenspannung gemessen wird, ist eine im Zeigerdiagramm in der beigefügten Fig. 3 mit $U_s'$ bezeichnete Spannung, die sich aus $U_R$, $U_L$ (dem durch den Schweißstrom verursachten ohmschen plus induktiven Spannungsabfall) und den eingestreuten induzierten Spannungen $U_{EK} + \Delta U_{EK} + U_i$ zusammensetzt. Die Spannung, die in der bekannten Meßschaltung als zweite Schleifenspannung gemessen wird, ist proportional zu der im vorgenannten Zeigerdiagramm mit $U_{EK}$ bezeichneten Spannung. Das Subtrahieren der beiden Schleifenspannungen soll bei der bekannten Meßschaltung den erwähnten ohmschen Spannungsabfall ergeben, obgleich der induktive Spannungsabfall $U_L$ in der zweiten Schleifenspannung nicht enthalten ist. Diese Meßmethode ist daher relativ ungenau. Weiter ist diese Meßmethode ungenau, weil beide Meßschleifen weit voneinander entfernt sind und daher unterschiedliche eingestreute Spannungen messen werden. Ein induzierter Spannungsanteil $\Delta U_{EK}$ als Funktion der sich im Schweißfenster befindlichen Dosenrümpfe (aus Weißblech, d.h. aus verzinntem Eisenblech) wird sich zwar in der ersten Meßschleife ergeben, nicht aber in der zweiten Meßschleife. Ferner ist die durch die erste Meßschleife umschlossene Fläche wesentlich größer als die der zweiten Meßschleife. Eingestreute Störeinflüsse $U_i$ wirken sich daher in der ersten Meßschleife stärker aus als in der zweiten Meßschleife. Bei der bekannten Meßschaltung ist zwar vorgesehen, die Verstärkungen von Verstärkern, die in den beiden Meßschleifen vorgesehen sind, so zu wählen, daß die zweite Schleifenspannung, die im wesentlichen induktiv ist, ungefähr die gleiche Größe hat wie die Blindkomponente der ersten Schleifenspannung, diese Wahl läßt sich jedoch nur für einen ganz bestimmten Arbeitspunkt treffen. Für alle anderen Arbeitspunkte ist dann das Meßergebnis zu ungenau, denn die Eisenmenge im Schweißfenster, die die Einstreuungen hauptsächlich beeinflußt, ändert sich während des Schweißens ständig. Da der Schweißstrom als während jedes Schweißvorganges im wesentlichen konstant vorausgesetzt werden kann, werden Feldverlauf und Felddichte im Bereich der ersten Meßschleife also hauptsächlich durch den sich ändernden Eisengehalt verändert. Zumindest diese Änderung kann die zweite Meßschleife aber nicht erfassen, weil sie entfernt von dem Schweißfenster neben der oberen Sammelschiene angeordnet ist und daher nur von deren Feld beeinflußt wird.

Bei einer weiteren bekannten Meßschaltung (US-PS 4 714 816) wird der Spannungsabfall an der Schweißstelle mittels eines Hall-Elements über den Schleifenstrom in einer Schleife gemessen, die durch eine über die Elektrodenrollen geleitete Flachdrahtelektrode gebildet wird. Der Schleifenstrom umfaßt eine induktive Komponente, die eine Folge des Magnetfelds ist, das in der Schleife durch den Schweißstrom erzeugt wird. In dieser Schleife wird also effektiv eine Spannung $U_s''$ gemessen, d.h. eine Spannung ohne die Störeinflüsse $U_i$. Mit einem weiteren Hall-Element wird in einer zweiten Schleife die Feldstärke gemessen, die von Schweißstrom her rührt. Der variable Teil $\Delta U_{EK}$ der induzierten Spannung, der von der Anzahl der Dosenrümpfe im Schweißfenster abhängig ist, wird auch bei dieser bekannten Meßschaltung in der zweiten Meßschleife nicht erfaßt, weshalb dieser variable Teil auch durch Subtraktion der beiden Schleifenspannungen nicht kompensiert werden kann. Das durch die Subtraktion gebildete Signal hat daher ziemlich große Schwankungen, die bei der Auswertung der Schweißqualität bei den letzten Dosenrümpfen Auflösungsprobleme ergeben.

Mit der GB-A- 2 127 564 ist ein Verfahren und eine Einrichtung für elektrisches Punktschweissen bekannt geworden, bei welchen induktive Kopplung zwischen den Schweissstromleitern und den Leitern einer Messschleife zur Ermittlung des Spannungsabfalls an der Schweissstelle vermieden wird. Hierbei sind die Leiter der Messschleife an den als Schweissstromleiter dienenden Schweissarmen angeschlossen. Die Anschlusspunkte sind so weit von den Schweisselektroden entfernt, dass die Leiter der Messschleife nicht von dem zu verschweissenden Gegenstand beschädigt werden können. Ausserdem soll mit dieser Anordnung der Anschlusspunkte erreicht werden, dass die Leiter, wie das bei Befestigung in unmittelbarer Nähe der Schweisselektroden erforderlich wäre, nicht parallel zu den Schweissarmen verlaufend verlegt werden müssen, so dass induktive Kopplung vermieden wird. Die beiden Leiter der Messschleife sind miteinander verdrillt und mit einer Steuerungseinrichtung verbunden. Ueber die beiden Leiter werden der Steuerungseinrichtung Signale in Form des Spannungsverlaufes während des Schweissvorganges zugeführt. Hierbei wird der Schweissvorgang abgebrochen, wenn nach Auftreten eines Spitzenwertes der Spannung diese auf einen vorbestimmten, niedrigeren Wert abgesunken ist. Der vorherbestimmte Wert ist dabei so gewählt, dass eine bestimmte notwendige Grösse des Schweisspunktes erreicht wird.

Aufgabe der Erfindung ist es, eine Schaltung der eingangs genannten Art so zu verbessern, dass der Spannungsabfall an der Schweissstelle wesentlich genauer gemessen werden kann.

Diese Aufgabe wird durch die im Patentanspruch 1 gekennzeichnete Erfindung gelöst. Hierbei sind die zweiten Abgreifpunkte in unmittelbarer Nähe der Schweissstelle angeordnet. Die Leiter der ersten und zweiten Messschleife weisen annähernd die gleiche Länge auf, wobei beide Messschleifen im wesentlichen dieselbe Fläche einschliessen und - ausser im Bereich zwischen den Abgreifpunkten - miteinander verdrillt sind. Mit der ersten Messschleife wird ein effektiver Spannungsabfall plus Einstreuungen gemessen, während die zweite Messschleife nur die Einstreuungen misst.

Bei der Schaltung nach der Erfindung sind die beiden Messschleifen praktisch gleich gross und liegen praktisch am selben Ort, d.h. sie umschliessen dieselbe Fläche. Sämtliche Einstreuungen in die beiden Messschleifen beeinflussen daher die Messschleifen jeweils in demselben Ausmass. Wenn dann erfindungsgemäss die beiden Schleifenspannungen voneinander subtrahiert werden, ist das Ergebnis der effektive Spannungsabfall $U_S$ an der Schweissstelle. Die Einstreuungen $U_E$ (d.h. $U_{EK}$ + $\triangle U_{EK}$) und $U_i$ werden daher in der Schaltung nach der Erfindung genau kompensiert, und zwar in jedem beliebigen Arbeitspunkt, da ihr Einfluss auf die beiden Messschleifen immer derselbe ist. Dabei erstreckt sich in der Schaltung nach der Erfindung die erste Messschleife bis zu den beiden Abgreifpunkten an den Schweisselektroden und misst als erste Schleifenspannung $U_S'$ den effektiven Spannungsabfall $U_S$ plus die Einstreuungen $U_E$ und $U_i$, und die zweite Messschleife (Kompensationsschleife) wird als geschlossene Wicklung möglichst nahe an beiden Schweisselektroden vorbeigeführt und misst als zweite Schleifenspannung die Einstreuungen $U_E$ und $U_i$. Aufgrund der gegenseitigen Verdrillung sind beide Messschleifen so verlegt, dass die Fläche zwischen ihren Drähten praktisch gleich null ist. Daher ist die erzielte Spannung $U_S$ stets genau die Differenz zwischen $U_S'$ und $U_E$ plus $U_i$.

Vorteilhafte Ausgestaltungen der Erfindung bilden den Gegenstand der abhängigen Ansprüche.

In der Ausgestaltung der Erfindung nach Anspruch 2 ist die Weiterverarbeitung der gemessenen Spannungen am einfachsten. Es wäre aber ohne weiteres auch möglich, die Meßschleifen jeweils aus mehreren Leiterwindungen herzustellen.

In der Ausgestaltung der Erfindung nach Anspruch 3, in der die Schaltung nach der Erfindung bei einer Widerstandsrollennahtschweißmaschine zum Schweißen von Dosenrümpfen benutzt wird, bildet im Bereich der Z-Schiene deren Kopfteil, an dem die zweiten Abgreifpunkte angeordnet sind, den betreffenden Teil der zweiten Meßschleife und reicht daher bis in unmittelbarste Nähe der Schweißstelle.

In der Ausgestaltung der Erfindung nach Anspruch 4 ermöglicht der Schleifkontakt, den betreffenden Abgreifpunkt möglichst nahe an die Schweißstelle zu verlegen.

Ein Ausführungsbeispiel der Erfindung wird im folgenden unter Bezugnahme auf die Zeichnung näher beschrieben. Es zeigt

Fig. 1    einen Teil einer Widerstandsnahtschweißmaschine mit der Schaltung nach der Erfindung,

Fig. 2    in vergrößerter Darstellung den Bereich um die Schweißstelle bei der Widerstandsnahtschweißmaschine nach Fig. 1, und

Fig. 3    ein zur Erläuterung dienendes Zeigerdiagramm, auf das in der Beschreibungseinleitung bereits Bezug genommen worden ist.

Bei der folgenden Beschreibung einer Schaltung zum Messen des Spannungsabfalls an der Schweißstelle zwischen den Schweißelektroden einer Widerstandsschweißmaschine wird zwar auf eine Widerstandsnahtschweißmaschine zum Längsnahtschweißen von Dosenrümpfen Bezug genommen, die beschriebene Schaltung ist jedoch bei anderen Widerstandsschweißmaschinen wie Punktschweißmaschinen, Buckelschweißmaschinen und dgl. ebenso verwendbar.

In Fig. 1 sind von der Widerstandsnahtschweißmaschine nur die für das Verständnis der Erfindung wesentlichsten Teile dargestellt. Zu schweißende Dosenrümpfe 10 werden in Fig. 1 von links nach rechts auf einer sogenannten Z-Schiene 12 geführt und zur Längsnahtschweißung zwischen eine obere Elektrodenrolle 14 und eine untere Elektrodenrolle 16 mittels einer nicht dargestellten Transportkette eingeführt. Nähere Einzelheiten dazu finden sich in der auf die Anmelderin selbst zurückgehenden DE-OS 25 59 671. Die obere Elektrodenrolle 14 ist gemäß Fig. 2 an einem Ende einer Welle 18 befestigt, die am anderen Ende in einem nicht dargestellten Pendelrollenkopf drehbar gelagert ist. An dem der oberen Elektrodenrolle 14 benachbarten Ende ist die Welle 18 am Ende eines schwenkbar gelagerten Bügels 20 befestigt, der die obere Elektrodenrolle 14 vertikal und in Schweißrichtung führt. Gemäß den Figuren 1 und 2 ist über die obere Elektrodenrolle 14 eine Flachdrahtelektrode 22 geführt, die einen rechteckigen Querschnitt aufweist. Eine gleiche Flachdrahtelektrode 24 ist über die untere Elektrodenrolle 16 geführt. Die beiden Flachdrahtelektroden 22, 24 werden gemäß Fig. 1 auf der linken Seite zu- und weggeführt. Solche Flachdrahtelektroden dienen dem Zweck, die Verunreinigung der Elektrodenrolle durch das Eingehen einer Verbindung mit Metall des Schweißgutes (z.B. Zinn, wenn Dosenrümpfe aus Weißblech zu schweißen sind) zu verhindern. Die untere Elektrodenrolle 16 besteht aus einem Rotor, der auf einem Stator drehbar gelagert ist, welcher auf einer Achse 26 befestigt ist, die in einen unteren Schweißarm 28 eingespannt ist, welcher an der Einspannstelle zu diesem Zweck geteilt ist. Über den unteren Schweißarm 28 wird der Schweißstrom zugeführt, wobei die Stromübertragung zwischen dem Stator und dem Rotor der unteren Elektrodenrolle 16 durch Flüssigmetall erfolgt. Die Schweißstelle 30 befindet sich also zwischen den beiden Elektrodenrollen 14, 16, genauer gesagt, zwischen den beiden Flachdrahtelektroden 22, 24.

Der vorstehend beschriebene Aufbau der Widerstandsnahtschweißmaschine ist herkömmlich. Die Schaltung zum Messen des effektiven Spannungsabfalls $U_S$ (vgl. Fig. 3) wird nun beschrieben.

Die Schaltung weist eine erste Meßschleife 40 und eine zweite Meßschleife 60 auf. Beide Meßschleifen bestehen aus jeweils einer Leiterwindung 42 bzw. 62. Die Leiterwindung 42 führt von einem Eingang einer elektronischen Auswerteschaltung 48 zu zwei Abgreifpunkten 44 und 46, die an der oberen Elektrodenrolle 12 bzw. am unteren Schweißarm 28 vorgesehen sind. Zwischen den beiden Abgreifpunkten 44, 46 ist die erste Meßschleife über die obere Elektrodenrolle 14, die Schweißstelle 30, die untere Elektrodenrolle 16 und deren Achse 26 geschlossen. Die Leiterwindung 62 führt von einem weiteren Eingang der elektronischen Auswerteschaltung 48 zu zwei Befestigungspunkten 64, 66 am Kopfteil der Z-Schiene 12, die sich daher in unmittelbarer Nähe der Elektrodenrollen befinden. Die beiden Leiterwindungen 42, 62 sind miteinander verdrillt, so daß induktive Einstreuungen von außen auf die beiden Meßschleifen absolut gleich sind. An den Eingängen zur elektronischen Auswerteschaltung 48 sind die beiden Meßschleifen jeweils durch einen Widerstand $R_1$ bzw. $R_2$ (von z.B. jeweils 50 Ohm) abgeschlossen. Die erste Meßschleife 40 mißt die Spannung

$$U_S^{'} = U_S + U_{EK} + \Delta U_{EK} + U_i = U_S + U_E + U_i$$

Die zweite Meßschleife 60 mißt die gleiche Spannung, allerdings ohne den Anteil $U_S$. In der Auswerteschaltung 48 wird daher die effektive Spannung $U_S$ als die Differenz der beiden Schleifenspannungen ermittelt, die dann wie im Stand der Technik für Überwachungs- oder Steuerzwecke weiterverarbeitet wird. Der auf diese Weise ermittelte Wert des effektiven Spannungsabfalls $U_S$ ist sehr genau, weil beide Meßschleifen im wesentlichen dieselbe Fläche einschließen und - außer in dem Bereich zwischen den beiden Abgreifpunkten 44, 46 - miteinander verdrillt sind.

Gemäß der ausführlicheren Darstellung in Fig. 2 ist zur Bildung des Abgreifpunktes 44 an der oberen Elektrodenrolle 14 an dem Bügel 20 ein Bürstenhalter 50 befestigt, der eine Bürste 52 trägt, die durch eine nicht dargestellte Feder gegen die obere Elektrodenrolle 14 gedrückt wird. Der Abgreifpunkt 44 besteht daher aus einem Schleifkontakt. Über eine Klemme 54 ist die Leiterwindung 42 angeschlossen. Am anderen Ende hat die Leiterwindung 42 eine den Abgreifpunkt 46 bildende Klemme 56, mit der sie an den Unterarm 28 durch eine Schraubbefestigung angeschlossen ist. Mittels entsprechender Klemmen und Schraubbesfestigungen ist die Leiterwindung 62 auf in Fig. 2 dargestellte Weise an den Kopfteil der Z-Schiene 12 angeschlossen.

Liste der in der Beschreibung und in Fig. 3 verwendeten Spannungssymbole

$U_R$ = ohmscher Spannungsabfall aufgrund des Schweißstroms

$U_L$ = induktiver Spannungsabfall aufgrund des Schweißstroms

$U_S = U_R + U_L$ = effektiver Spannungsabfall

$U_{EK}$ = in der Meßschleife induzierte Spannung

$\Delta U_{EK}$ = von der Anzahl der Dosenrümpfe im Schweißfenster abhängiger induzierter Spannungsanteil, der in der Meßschleife induziert wird

$U_i$ = eingestreute Störeinflüsse

$U_E = U_{EK} + U_{EK}$

$U_S' = U_S + U_{EK} + \Delta U_{EK} + U_i = U_S + U_E + U_i$

$U_S'' = U_S + U_E$

## Patentansprüche

**1.** Schaltung zum Messen des Spannungsabfalls an der Schweissstelle zwischen den Schweisselektroden einer Widerstandsschweissmaschine, mit einer zur Messung einer ersten Schleifenspannung vorgesehenen ersten Messschleife (40), die einerseits mit Eingängen einer Auswerteschaltung (48) und anderseits mit zwei ersten Abgreifpunkten (44,46) an den Schweisselektroden (14,16) verbunden ist, und mit einer zur Messung einer zweiten Schleifenspannung vorgesehenen zweiten Messschleife (60), die einerseits an weiteren Eingängen der Auswerteschaltung (48) und anderseits an zwei zweiten Abgreifpunkten (64,66) angeschlossen ist, wobei die Auswerteschaltung (48) die zweite Schleifenspannung von der ersten subtrahiert, und wobei die erste Messschleife (40) einen effektiven Spannungsabfall ($U_S$) plus Einstreuungen ($U_E$, $U_i$) misst, dadurch **gekennzeichnet,** dass die zweiten Abgreifpunkte (64,66) in unmittelbarer Nähe der Schweissstelle (30) angeordnet sind, und dass die die erste und zweite Messschleife (40,60) bildenden Leiter annähernd die gleiche Länge aufweisen, wobei beide Messschleifen (40,60) im wesentlichen dieselbe Fläche einschliessen und - ausser im Bereich zwischen den Abgreifpunkten (44,46 bzw. 64,66) - miteinander verdrillt sind, und wobei die zweite Messschleife (60) nur die Einstreuungen ($U_E$, $U_i$) misst.

**2.** Schaltung nach Anspruch 1, dadurch gekennzeichnet, dass beide Messschleifen (40, 60) aus jeweils einer Leiterwindung (42, 62) bestehen.

**3.** Schaltung nach Anspruch 1, für eine Widerstands-Nahtschweissmaschine mit einer Z-Schiene (12) als Führung für der Schweissstelle (30) zugeführte Dosenrümpfe (10), dadurch gekennzeichnet, dass die zweiten Abgreifpunkte (64,66) an dem der Schweissstelle (30) unmittelbar benachbarten Kopfteil der Z-Schiene (12) angeordnet sind, wobei ein Teil der zweiten Messschleife (60) zwischen den beiden zweiten Abgreifpunkten (64,66) durch den genannten Kopfteil gebildet ist.

**4.** Schaltung nach Anspruch 3, dadurch gekennzeichnet, dass die ersten Abgreifpunkte (44, 46) der ersten Messschleife (40) eine Klemme (56) am Unterarm (28) bzw. ein Schleifkontakt (52) an der oberen Schweisselektrode (14) sind.

## Claims

**1.** Circuit for measuring the voltage drop at the welding position between the welding electrodes of a resistance welding machine, having a first measuring loop (40) provided to measure a first loop voltage and connected on the one hand to inputs of an evaluation circuit (48) and on the other to two first tapping points (44, 46) on the welding electrodes (14, 16), and having a second measuring loop (60) provided to measure a second loop voltage and connected on the one hand to additional inputs of the evaluation circuit (48) and on the other to two second tapping points (64, 66), the evaluation circuit (48) subtracting the second loop voltage from the first loop voltage, and the first measuring loop (40) measuring an effective voltage drop ($U_S$) plus parasitics ($U_E$, $U_i$), characterised in that the second tapping points (64, 66) are arranged immediately adjacent to the welding point (30) and that the conductors constituting the first and second measuring loops (40, 60) have approximately the same length, the two measuring loops (40, 60) enclosing substantially the same area and being twisted together - except for in the region between the tapping points (44, 46 and 64, 66, respectively), and the second measuring loop (60) measuring only the parasitics ($U_E$, $U_i$).

**2.** Circuit according to claim 1, characterised in that the two measuring loops (40, 60) each consist of a conductor turn (42, 62).

**3.** Circuit according to claim 1, for a resistance seam-welding machine having a Z-rail (12) as a guide for can bodies (10) supplied to the welding position (30), characterised in that the second capping points (64, 66) are arranged on the head portion of the Z-rail (12) immediately adjacent to the welding position (30), and a portion of the second measuring loop (60) between the two second tapping points (64, 66) is constituted by said head portion.

**4.** Circuit according to claim 3, characterised in that the first tapping points (44, 46) of the first measuring loop (40) are respectively a terminal (56) on the lower arm (28) and a sliding contact (52) on the upper welding electrode (14).

**Revendications**

1. Circuit pour mesurer la chute de tension dans la zone de soudage entre les électrodes de soudage d'une machine à souder par résistance, comportant une première boucle de mesure (40), prévue pour la mesure d'une première tension de boucle et qui est raccordée, d'une part, à des entrées d'un circuit d'évaluation (48) et d'autre part à deux premiers points de prélèvement (44,46) sur les électrodes de soudage (14,16), et une seconde boucle de mesure (60) prévue pour la mesure d'une seconde tension de boucle et qui est raccordée, d'une part , à d'autres entrées du circuit d'évaluation (48) et, d'autre part, à deux seconds points de prélèvement (64,66), et dans lequel le circuit d'évaluation (48) soustrait la seconde tension de boucle de la première tension de boucle, et la première boucle de mesure (40) mesure une chute de tension efficace ($U_S$) plus des dispersions ($U_E$,$U_i$), caractérisé en ce que les seconds points de prélèvement (64,66) sont disposés à proximité directe de la zone de soudage (30) et que les conducteurs constituant les première et seconde boucles de mesure (40,60) possèdent approximativement la même longueur, les deux boucles de mesure (40,60) entourant essentiellement la même surface et étant réunies entre elles par torsadage - hormis dans la zone située entre les points de prélèvement (44, 46 ou 64, 66), et la seconde boucle de mesure (60) ne mesurant que les perturbations ($U_E$, $U_i$).

2. Circuit selon la revendication 1, caractérisé en ce que les deux boucles de mesure (40,60) sont constituées chacune par une spire de conducteur (42,62).

3. Circuit selon la revendication 1 pour une machine à souder à résistance en ligne continue comportant un rail en forme de Z (12) servant de guide pour des corps de boites (10) amenés à la zone de soudage (30), caractérisé en ce que les seconds points de prélèvement (64,66) sont disposés sur la partie de tête du rail en forme de Z (12), qui est directement voisine de la zone de soudage (30), une partie de la seconde boucle de mesure (60) étant formée entre les deux seconds points de prélèvement (64,66) par ladite partie de tête.

4. Circuit selon la revendication 3, caractérisé en ce que les premiers points de prélèvement (44,46) de la première bouche de mesure (40) sont constitués par une borne (56) située sur le bras inférieur (28) ou par un contact glissant (52) situé sur l'électrode supérieure de soudage (14).

Fig. 1

Fig. 2

Fig. 3